Europäisches Patentamt

European Patent Office

Office européen des brevets

(11) Numéro de publication: **0 156 694**
**A1**

## (12) DEMANDE DE BREVET EUROPEEN

(21) Numéro de dépôt: 85400360.5

(22) Date de dépôt: 26.02.85

(51) Int. Cl.⁴: **H 03 F 1/02**

(30) Priorité: 28.02.84 FR 8403032

(43) Date de publication de la demande:
02.10.85 Bulletin 85/40

(84) Etats contractants désignés:
CH DE GB IT LI SE

(71) Demandeur: THOMSON-LGT LABORATOIRE GENERAL
DES TELECOMMUNICATIONS
51, boulevard de la République
F-78400 Chatou(FR)

(72) Inventeur: Nollet, Michel
THOMSON-CSF SCPI 173, bld Haussmann
F-75379 Paris Cedex 08(FR)

(74) Mandataire: Lincot, Georges et al,
THOMSON-CSF SCPI 173, Bld Haussmann
F-75379 Paris Cedex 08(FR)

(54) Dispositif de polarisation d'étage d'amplification à transistors, et son utilisation dans un tel étage.

(57) L'invention a pour objet un dispositif de polarisation d'étage d'amplification à transistors dans lequel le courant de polarisation de collecteur de chaque transistor amplificateur (1) est maintenu constant au moyen d'un circuit de comparaison (2) d'un signal image du courant de polarisation de collecteur et d'un signal de référence, le signal d'erreur ($v_e$) résultant étant utilisé comme signal de commande d'un régulateur de courant à découpage (4, 6, $D_2$, $L_2$, $C_1$) qui fournit la puissance de polarisation de base au transistor amplificateur (1).

Application, notamment, aux amplificateurs dans lesquels une réduction de consommation de puissance est recherchée.

Fig.2

1

Dispositif de polarisation d'étage d'amplification
à transistors et son utilisation dans un tel étage.

L'invention se rapporte aux étages d'amplification à transistors et plus particulièrement à leurs circuits de polarisation.

Les étages d'amplification, utilisés par exemple dans les émetteurs ou réémetteurs de télévision, consomment une certaine puissance, une fraction de cette puissance étant consommée par le circuit de polarisation. Le problème à résoudre est la réduction de la consommation de tels équipements, notamment dans deux cas importants :

- d'une part lorsque l'équipement est de faible puissance et consomme assez peu, mais que l'énergie est très chère, par exemple dans les sites isolés où l'alimentation est réalisée au moyen de cellules solaires, d'aérogénérateurs etc... ; dans ce cas la réduction de la puissance consommée entraîne essentiellement une réduction des frais d'exploitation.

- et d'autre part lorsque l'équipement est de forte puissance et consomme beaucoup ; dans ce cas la réduction de puissance consommée entraîne une réduction de la puissance thermique dissipée qui réduit surtout les coûts de fabrication et d'installation (ventilation et climatisation.

Pour atteindre ce but, il est tout d'abord possible d'améliorer le rendement des alimentations mais il n'est pas possible d'aller trop loin dans ce sens lorsque l'on atteint des rendements proches des limites possibles : entre 80 et 90 %, chaque gain sur ce rendement conduit à augmenter considérablement le coût de fabrication de l'alimentation.

Pour diminuer la consommation de l'équipement, l'invention se propose d'améliorer le rendement des amplificateurs de puissance puisque ce sont ceux qui consomment la plus grande partie de l'énergie fournie aux équipements. Dans les étages de puissance en effet chaque amplificateur est composé d'un ou plusieurs transistors HF, par exemple 64 transistors pour produire 1 kilowatt en VHF. Le rendement de l'amplificateur est fonction, entre autres paramètres, de la classe d'amplification choisie.

Les exigences de qualité sur le signal amplifié imposent d'utiliser les classes d'amplification A ou AB pour éviter les distorsions, ces classes d'amplification ayant un rendement généralement mauvais. Les amplificateurs en classe A sont en général polarisés à courant collecteur constant ; pour cela une tension image du courant collecteur dans le transistor de puissance est comparée à une tension de référence, obtenue au moyen d'un diviseur de tension de la tension d'alimentation, dans un comparateur.Ce comparateur fournit un courant de base régulé pour obtenir un courant collecteur constant sous une tension qui est la tension d'alimentation. Le rendement en puissance de cet étage de polarisation est très faible.

L'invention a pour objet un dispositif de polarisation d'étage d'amplification à transistors ayant un rendement nettement supérieur à celui des circuits de polarisation utilisés classiquement dans les étages d'amplification à transistors. Pour cela, le comparateur qui fournit la puissance à la base du transistor HF est remplacé par un circuit à découpage, l'ensemble du circuit à polarisation formant ainsi un régulateur de courant à découpage.

L'invention a également pour objet l'utilisation d'un tel dispositif de polarisation dans un étage d'amplification à transistors.

Suivant l'invention un dispositif de polarisation d'étage d'amplication à transistors, dans lequel, pour chaque transistor, un courant de polarisation est maintenu constant au moyen d'un circuit de comparaison d'un signal image de ce courant de polarisation et d'un signal de référence, est caractérisé ence que le signal d'erreur résultant de la comparaison est utilisé pour générer un signal de commande d'un régulateur de courant à découpage fournissant la puissance de polarisation de base de ce transistor.

L'invention sera mieux comprise et d'autres caractéristiques apparaîtront à l'aide de la description qui suit en référence aux figures annexées.

La figure 1 représente un étage d'amplification à transistors en classe A, polarisé par un circuit de polarisation classique.

La figure 2 représente un étage d'amplification à transistors avec un dispositif de polarisation suivant un mode de réalisation de l'invention.

3

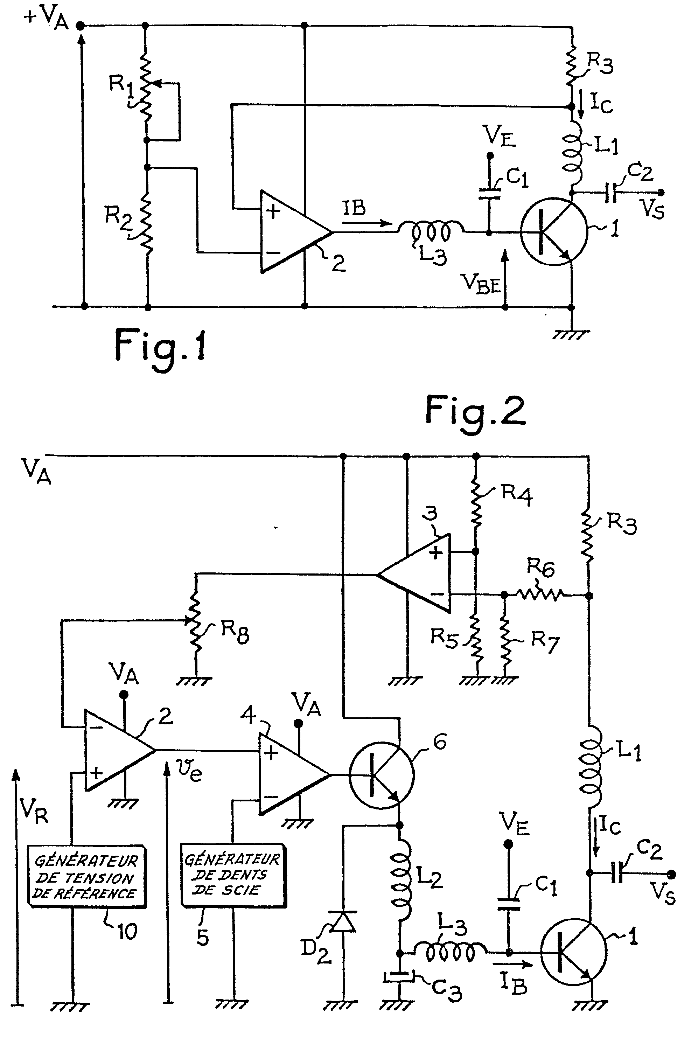

Sur la figure 1 qui représente l'art connu, un transistor HF de puissance 1 a son émetteur relié à la masse et son collecteur relié à la tension d'alimentation positive +$V_A$ par l'intermédiaire d'une résistance de collecteur $R_3$. Le courant collecteur est $I_C$. La base de ce transistor 1 est reliée par l'intermédiaire d'une self de choc L3 à la sortie d'un comparateur dont l'entrée "+" est reliée au point commun de R3 et L1 et dont l'entrée "-" est reliée au point milieu d'un diviseur de tension, entre la masse et +$V_A$, constitué de deux résistances $R_1$ et $R_2$. Le courant de polarisation $I_B$ dans la base du transistor HF est tel que la différence de potentiel entre les entrées du comparateur est maintenue égale à zéro,

soit $R_3 \times I_C = \dfrac{V_A R_1}{R_1+R_2}$ . Le courant constant dans le collecteur peut être réglé par l'intermédiaire de la résistance $R_1$ variable à la valeur souhaitée : $I_C = \dfrac{R_1 \times V_A}{R_3 (R_1+R_2)}$ .

Le signal à amplifier $V_E$ est appliqué à la base du transistor HF d'amplification 1, via un condensateur $C_1$ et le collecteur du transistor HF fournit le signal de sortie $V_S$ par l'intermédiaire d'un condensateur $C_2$.

Le comparateur 2 peut être un amplificateur opérationnel, un amplificateur différentiel ou un montage plus simple n'utilisant qu'un ou deux transistors. Tous ces montages connus ont un défaut commun : leur "étage de puissance" qui fournit le courant de base $I_B$ au transistor HF draîne ce courant $I_B$ sous la tension $V_A$ ; il consomme donc une puissance $P = V_A \times I_B$ alors qu'il ne fournit qu'une puissance p au transistor HF :

$p = V_{BE} \times I_B$.

Le rendement en puissance de cet étage de polarisation est donc égal à $\dfrac{p}{P}$ soit, si $V_A$ = 30 volts et $V_{BE}$ = 1 volt, un rendement de l'ordre de 3,3 %.

De même, le rapport de la puissance consommée par le circuit de polarisation à la puissance utile consommée par le transistor HF atteint en règle générale plusieurs pourcents, et, dans le contexte indiqué ci-dessus c'est-à-dire lorsque la puissance est chère, ces quelques pourcents peuvent entraîner un surcoût important pour le fonctionnement de l'équipement.

A titre d'exemple, avec les valeurs $V_A$ et $V_{BE}$ indiquées ci-dessus, lorsque le gain en courant statique $\beta$ du transistor HF est égal à 20, le rapport entre la puissance de polarisation et la puissance utile avoisine les

5 %. Lorsque $\beta$ = 50 ce rapport est encore voisin de 2% et lorsque $\beta$ = 100 ce rapport est voisin de 1%.

La figure 2 représente le dispositif de polarisation d'étage d'amplification à transistors selon un mode de réalisation de l'invention. Sur cette figure, comme sur la figure précédente, le transistor HF,1, NPN a son émetteur relié à la masse et son collecteur relié à la tension d'alimentation positive $V_A$ par l'intermédiaire d'une résistance $R_3$ en série avec une self de choc $L_1$. La résistance $R_3$, comme dans le cas précédent, permet "de mesurer" le courant collecteur. Pour cela, ses deux bornes sont reliées aux deux entrées d'un amplificateur de tension 3 par l'intermédiaire de deux ponts de résistances, l'un $R_4$, $R_5$ entre la tension d'alimentation et la masse son point milieu étant relié à l'entrée "+", et l'autre $R_6$, $R_7$ entre l'autre borne de la résistance $R_3$ et la masse, son point milieu étant relié à l'entrée "-" de l'amplificateur de tension. La tension de sortie de cet amplificateur est donc une tension "image" amplifiée du courant $I_C$ de polarisation du collecteur du transistor HF. Cette sortie est reliée à la masse par l'intermédiaire d'un rhéostat $R_8$ dont la borne variable est reliée à l'entrée "-" d'un comparateur 2 analogue à celui utilisé dans le circuit de la figure 1. Une tension de référence $V_R$ issue d'un générateur de tension de référence 10 est appliquée sur la borne "+" du comparateur 2. La sortie du comparateur 2 fournit donc une tension d'erreur $v_e$ à partir de laquelle va être réglé le courant de base $I_B$ du transistor HF.

Dans le dispositif suivant l'invention, la tension de sortie du comparateur 2 n'est pas appliquée directement à la base du transistor HF mais par l'intermédiaire d'un circuit à découpage de la manière suivante : la sortie du comparateur 2 est reliée à l'entrée "+" d'un comparateur 4 qui reçoit sur son entrée "-" un signal en dents de scie provenant d'un générateur de dents de scie 5. La sortie de ce comparateur est reliée à la base d'un transistor de découpage fonctionnant comme un interrupteur rapide, 6. L'émetteur de ce transistor est relié à une self de découpage $L_2$ en série avec un condensateur $C_3$ relié d'autre part à la masse. Le point commun à cette self de découpage $L_2$ et à ce condensateur $C_3$ est relié à une self de choc HF, $L_3$, dont l'autre borne est reliée à la base du transistor 1. Enfin l'émetteur du transistor de découpage 6 est également relié à la masse par l'intermédiaire d'une diode de récupération $D_2$. Le signal à amplifier $V_E$ est par ailleurs appliqué à la base du transistor d'amplification 1 via le condensateur $C_1$ de manière connue, et le collecteur du transistor HF fournit le signal à la sortie $V_S$ par l'intermédiaire du condensateur $C_2$.

Ainsi, le courant de polarisation de base du transistor 1 est ajusté pour que le courant collecteur ait une valeur donnée, valeur à laquelle est associée la tension de référence $V_R$, mais ce courant de base est fourni par un circuit à découpage dont le rendement est de l'ordre de 80%.

En conséquence la puissance p fournie à la base du transistor, $p = I_B.V_{BE}$ comme dans le cas de la figure 1, est maintenant fournie par un circuit de polarisation qui ne consomme que 20% de plus que la puissance fournie à la base du transistor, alors que dans le cas précédent le circuit de polarisation consommait à peu près 29 fois la puissance fournie à la base. Le rapport entre la puissance consommée dans un circuit de polarisation selon l'invention et un circuit de polarisation classique est donc égal à $\frac{3,3}{80} = 4\%$, c'est -à-dire que le circuit de polarisation suivant l'invention consomme 96% de moins qu'un circuit classique, ce qui conduit à une amélioration notable en ce qui concerne le bilan global.

Avec un gain statique du transistor de puissance $\beta = 20$, le rapport entre la puissance de polarisation et la puissance utile est donc voisin de 0,2% contre 5% antérieurement ; avec un gain $\beta = 50$ ce rapport tombe à 0,08 % contre 2% et avec un gain $\beta = 100$, ce rapport n'est plus que de 0,04% contre 1% antérieurement.

L'intérêt d'un tel dispositif est évidemment d'autant plus grand que le nombre de transistors à polariser dans un étage d'amplification est grand et que les puissances consommées sont grandes car il est ainsi possible d'obtenir des réductions appréciables de la puissance consommée.

L'invention n'est pas limitée au mode de réalisation précisément décrit en référence à la figure 2.

En particulier, pour obtenir une tension image du courant de polarisation $I_C$ une résistance a été représentée dans le collecteur du transistor amplificateur. Cette résistance peut être remplacée par tout autre capteur permettant de donner une image du courant, ou du point de polarisation, par exemple par un capteur à effet Hall ou un capteur thermique. De plus la résistance a été placée sur la figure dans le collecteur, mais elle pourrait également être placée dans l'émetteur, ou dans la base du transistor amplificateur si la régulation était faite à courant de base constant.

De plus, le signal de référence comparé à la tension image du courant de polarisation à réguler, fixé par une diode Zener dans le circuit de la figure 2, peut être une grandeur variable, par exemple proportionnelle à l'amplitude du signal d'entrée $V_E$ à amplifier ou à un autre signal, tension, courant, ou grandeur quelconque, de façon à moduler le courant de polarisation du transistor amplificateur en fonction d'un signal ou d'un évènement. De plus, ce signal de référence peut être multiple. Par exemple, il peut être double : une référence basse au-dessous de laquelle le transistor de découpage est fermé et une référence haute dont le dépassement commande l'ouverture du transistor de découpage.

Le comparateur du signal image du courant de polarisation à réguler et du signal de référence peut être un comparateur simple ou à seuil, à hystérésis ou non. Dans l'exemple de la figure 2, le comparateur 2 est un amplificateur opérationnel. Il peut être remplacé par tout circuit équivalent.

Le circuit à découpage qui dans l'exemple de la figure 2 produit des créneaux à fréquence fixe et à rapport cyclique variable par comparaison du signal d'erreur $v_e$ avec un signal en dents de scie à fréquence constante. Cette disposition n'est évidemment pas limitative et le transistor de découpage peut être commandé par un signal formé de créneaux de largeur fixe et de fréquence variable, ou de créneaux de largeur et de fréquence variables, la valeur moyenne du signal de commande étant une fonction linéaire ou non, du signal d'erreur $v_e$. L'élément interrupteur créant le découpage peut être réalisé au moyen de tout circuit susceptible d'établir et d'interrompre un courant.

Le circuit "de puissance" auquel est transmis le courant issu de l'alimentation via l'élément interrupteur est principalement un étage d'intégration, bobine $L_2$ et condensateur $C_3$ dans le mode de réalisation de la figure 2. Ce circuit peut être complété par des circuits annexes à des fins d'adaptation d'impédance, de transformation de puissance ou de filtrage.

D'une manière générale toute configuration connue dans les systèmes d'alimentation à découpage ou dans les systèmes convertisseurs de puissance peut être adaptée pour être utilisée dans un dispositif de polarisation d'étage d'amplification à transistors suivant l'invention.

L'invention est applicable à tout amplificateur fonctionnant en classe A, quelle que soit la fréquence ou la forme du signal amplifié.

8

## REVENDICATIONS

1. Dispositif de polarisation d'étage d'amplification à transistors, dans lequel, pour chaque transistor, un courant de polarisation est maintenu constant au moyen d'un circuit de comparaison (2) d'un signal image de ce courant de polarisation et d'un signal de référence ($V_R$), caractérisé en ce que le signal d'erreur ($v_e$) résultant de la comparaison est utilisé pour générer un signal de commande d'un régulateur de courant à découpage (4, 6, $D_2$, $L_2$, $C_1$) fournissant la puissance de polarisaiton de base de ce transistor (1).

2. Dispositif selon la revendication 1, caractérisé en ce que le régulateur comporte un circuit interrupteur de courant (6) branché entre la source d'alimentation et un circuit intégrateur ($L_2$, $C_3$) dont la sortie est reliée à la base du transistor amplificateur (1), cet interrupteur étant commandé par un signal à deux niveaux dont la composante moyenne est caractéristique du signal d'erreur ($v_e$).

3. Dispositif selon la revendication 3, caractérisé en ce que le régulateur comporte en outre, pour former le signal de commande du circuit interrupteur à partir du signal d'erreur, un modulateur de forme d'onde (4, 5).

4. Dispositif selon l'une des revendications 1 à 3, caractérisé en ce que chaque transistor est polarisé à courant collecteur constant, le signal image étant caractéristique du courant collecteur ($I_C$).

5. Utilisation d'un dispositif de polarisation selon l'une quelconque des revendications précédentes dans un étage d'amplification à transistors.

1/1

Fig.1

Fig.2

Office européen
des brevets

# RAPPORT DE RECHERCHE EUROPEENNE

EP  85 40 0360

## DOCUMENTS CONSIDERES COMME PERTINENTS

| Catégorie | Citation du document avec indication. en cas de besoin, des parties pertinentes | Revendication concernée | CLASSEMENT DE LA DEMANDE (Int. Cl.4) |
|---|---|---|---|
| Y | PATENTS ABSTRACTS OF JAPAN, vol. 5, no. 133 (E-71)[805], 25 août 1981, page 92 E 71; & JP - A - 56 69 907 (NIPPON DENKI) 11-06-1981 * En entier * | 1-5 | H 03 F   1/02 |
| Y | FR-A-2 308 175  (SONY) * Figure 9; page 1, ligne 1 - page 3, ligne 4; page 11, ligne 10 - page 13, ligne 5 * | 1-5 | |
| A | DE-A-3 020 313  (ROHDE & SCHWARZ) | | |
| | | | DOMAINES TECHNIQUES RECHERCHES (Int. Cl.4) |
| | | | H 03 F |

Le présent rapport de recherche a été établi pour toutes les revendications

| Lieu de la recherche | Date d'achevement de la recherche | Examinateur |
|---|---|---|
| LA HAYE | 10-06-1985 | GYSEN L.A.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82